# EUROPEAN PATENT SPECIFICATION

(11) **EP 2 025 995 B1**
(45) Date of publication and mention of the grant of the patent: **07.07.2010**
(21) Application number: 08021248.3
(22) Date of filing: 17.09.2002
(51) Int. Cl.: F21V 14/06

(54) **Variable optics spot module**
Wechseloptikpunktmodul
Module de point lumineux à optique variable

(30) Priority: 17.09.2001 US 682535; 21.12.2001 US 683395
(43) Date of publication of application: 18.02.2009
(62) Divisional of application: 07000232.4
(73) Proprietor: Lumination, LLC, Valley View, OH 44125-4635 (US)
(72) Inventor: Sommers, Matthew, Sagamore Hills, OH 44067 (US); Petroski, James T., Parma, OH 44134 (US)
(74) Representative: Simcox, Michael Thomas

(56) References cited:
- EP-A- 1 072 884
- US-A- 5 580 163

## Description

### BACKGROUND OF THE INVENTION

### FIELD OF THE INVENTION

The invention relates to the lighting arts. It is especially applicable to the packaging of light emitting diodes (LED's) to form a spot light, flashlight, or other lamp type that produces a collimated or partially collimated beam, and will be described with particular reference thereto. However, the invention will also find application in packaging of LED's, semiconductor lasers, halogen bulbs, and other light emitting elements for spot lighting, flood lighting, and other optical applications.

### DISCUSSION OF THE ART

Spot light lamps emit a collimated or partially collimated beam of light (e.g., a conical beam), and are employed in room lighting, hand-held flash lights, theater spot lighting, and other applications. Examples of such lamps include the MR-series halogen spot lights which incorporate an essentially nondirectional halogen light bulb arranged within a directional reflector, such as a parabolic reflector. The MR-series halogen spot lights are commercially available with or without a front lens, and typically include electrical connectors dispose behind the parabolic reflector, i.e. outside of the range of the directed beam. The reflector, optionally in cooperation with a front lens, effectuates collimation of the halogen light bulb output to produce the collimated or conical light beam. The MR-series spot lights are available in a range of sizes, wattages, color temperatures, and beam angles. However, the MR-series spot lights do not include adjustable beams.

The Maglite® flashlight is a prior art device that has an adjustable spot beam. An incandescent light bulb is arranged inside an essentially parabolic reflector. This device effectuates a variable beam angle ranging from a narrow spot beam to a wide, "flood" beam, by including a rotating actuator for moving the reflector axially with respect to the incandescent bulb. This arrangement suffers from significant beam non-uniformity when the light source is strongly defocused. Under conditions of extreme defocusing, the Maglite® flashlight beam exhibits a black spot at the beam's center.

Lamps which utilize one or more LED's as the source of light are becoming more attractive as the light output intensities of commercial LED's steadily increase over time due to design, materials, and manufacturing improvements. Advantageously for spot module applications, commercial LED's typically have a lensing effect produced by the epoxy encapsulant that is usually employed to seal the LED chip from the environment. Hence, these commercial LED's are already somewhat directional, and this directionality can be enhanced using an external lens. Additionally, LED's that emit white light of reasonably high spectral quality are now available. In spite of continuing improvements in LED light output, at present an individual LED is typically insufficiently bright for most lighting applications. Nonetheless, due to the small size of LED's, this intensity limitation can be obviated through the use of a plurality of closely packed LED's that cooperate to produce sufficient light.

Application of LED's to spot lighting applications, and especially to spot lighting applications in which the LED-based lamp is contemplated as a retrofit for replacing an existing lamp that employs another lighting technology (e.g., a retrofit for replacing an MR-series halogen lamp) is complicated by the use of multiple LED's as the light source. The spatially distributed nature of an LED source array greatly reduces the effectiveness of conventional parabolic reflectors which are designed to collimate and direct light emanating from a point source, such as light generated by a halogen or incandescent bulb filament. Furthermore, a front lens of the type optionally included in an MR-series halogen spot lamp is ill-suited for collimating light from a plurality of LED's, because most of the LED's are not positioned on the optical axis of the lens. Thus, the optical systems of existing spot lamps, both with and without variable beam angle, are relatively ineffective when used in conjunction with LED light sources.

EP 1072884 discloses an illuminator that has a printed circuit board supporting a ring of light emitting diodes (LEDs). An annular Fresnel lens and the board are both mounted in a housing having a central through-hole for a camera field of view. The lens mixes light from the LEDs in the tangential direction and it also controls spread in the radial direction so there is uniform illumination over a target plane. Any individual point on the target plane receives illumination from over 25% of the light sources. The illuminator is thus particularly effective, compact, and suitable for a wide range of industrial applications. Choice of lens and of the spatial arrangement allows versatility. The illuminator design is easily scaleable by changing the size and spacing between the light sources. EP 1072884 also discloses that this arrangement may incorporate a threaded fitting for adjusting LED/lens separation.

US 5,580,163 discloses a single flexible mount and a simple adjustment system are used to provide the means to focus the collective outputs of multiple light-emitting elements. A plurality of light emitting elements are affixed to the flexible membrane. A physical means of flexing this membrane is provided so that the light from the collective outputs of the light emitting elements can be focused over a range of working distances. US 5,580,163 discloses the use a focus adjustment ring which may be turned to thread itself further down on an inside housing. This causes a downward displacement of an outside housing with respect to the inside housing which also causes a downward displacement of a mount outer ring and of an outside edge of a flexible light-emitting element mount. This results in angular displacement of the light-emitting elements.

The present invention contemplates an improved light source or lamp that overcomes the above-mentioned limitations and others.

### BRIEF SUMMARY OF THE INVENTION

In accordance with one embodiment of the present invention, there is provided lampe, die aufweist:
ein LED-Modul (86) mit mindestens einer LED (82), die auf einem Substrat (84) angeordnet ist,
mindestens eine Linse (88) in optischer Verbindung mit dem LED-Modul (86) längs einer optischen Achse zwischen der mindestens einen Linse (88) und der mindestens einen LED (82), und
eine Zoomvorrichtung (90), die den relativen axialen Abstand zwischen der mindestens einen Linse (88) und dem LED-Modul (86) auswählbar einstellt, **dadurch gekennzeichnet, dass** die Zoomvorrichtung (90) aufweist:
   zwei über Gewinde miteinander verbundene Hülsen (92, 94), wobei die erste Hülse (92) mit der mindestens einen LED (82) verbunden ist und die zweite Hülse (94) mit der mindestens einen Linse (88) verbunden ist.
.

In accordance with another embodiment of the present invention, there is provided a lamp including:
an LED module (16, 36) including at least one LED (12, 32) arranged on a substrate (14,34);
at least one lens (18, 38) in optical communication with the LED module (16, 36) along an optical axis between the at least one lens (18, 38) and the at least one LED (12, 32); and
a zoom apparatus (20, 40) that selectively adjusts the relative axial separation of the at least one lens (18, 38) and the LED module (16, 36), **characterized in that**
the zoom apparatus (40) includes:
   two slidably interconnected elements (42, 44), the first element (42) being connected with the at least one LED (32) and the second element (44) being connected to the at least one lens (38).
.

Numerous advantages and benefits of the present invention will become apparent to those of ordinary skill in the art upon reading and understanding the following detailed description.

### BRIEF DESCRIPTION OF THE DRAWINGS

The invention may take form in various components and arrangements of components, and in various steps and arrangements of steps. The drawings are only for purposes of illustrating a preferred embodiment and are not to be construed as limiting the invention.
FIGURE **1** shows an isometric view of a zoomable spot lamp that suitably practices an embodiment of the invention.
FIGURE **2** shows a schematic cross-sectional view of a zoomable spot lamp that suitably practices an embodiment of the invention, the lamp being shown as adjusted to produce a wide-angle flood beam.
FIGURE **3** shows a schematic cross-sectional view of the lamp of FIGURE 2, adjusted to produce a narrow-angle spot beam.
FIGURE **4** shows a front view of the lamp of FIGURE 2, looking directly into the beam, with dotted lines indicating the hidden sleeves of the zoom apparatus and the interlocking mechanism.
FIGURE **5** shows a schematic cross-sectional view of the lamp of FIGURE **2** in a first mounting configuration.
FIGURE **6** shows a schematic cross-sectional view of the lamp of FIGURE **2** in a second mounting configuration.
FIGURE **7** shows a schematic cross-sectional view of a zoomable spot lamp that suitably practices another embodiment of the invention, the lamp being shown as adjusted to produce a wide-angle flood beam.
FIGURE **8A** shows a front view of the lamp of FIGURE 7, looking directly into the beam, with the zoom apparatus rotated at a reference position, herein designated as 0°, between the first and second sleeves.
FIGURE **8B** shows a front view of the lamp of FIGURE 7, looking directly into the beam, with the second sleeve rotated 120° compared with its reference orientation of FIGURE **8A****.**
FIGURE **8C** shows a front view of the lamp of FIGURE 7, looking directly into the beam, with the second sleeve rotated 240° compared with its reference orientation of FIGURE **8A****.**
FIGURE **8D** shows a front view of the lamp of FIGURE 7, looking directly into the beam, with the second sleeve rotated slightly more than 240° compared with its reference orientation of FIGURE **8A**
FIGURE **9** shows a perspective view of another lamp or light source which suitably practices an embodiment of the invention;
FIGURE **10** shows a cross-sectional view of the lamp or light source of FIGURE **9** taken perpendicular to the substrate along the Line **L-L** shown in FIGURE **9****;**
FIGURE **11** shows an schematic representation of the electrical configuration of the lamp or light source of FIGURES **9** and **10****;**
FIGURE **12** shows a perspective view of a lamp or light source Which suitably practices another embodiment of the invention,; and
FIGURE **13** shows a perspective view of a lamp or light source which suitably practices yet another embodiment of the invention.

### DETAILED DESCRIPTION OF THE INVENTION

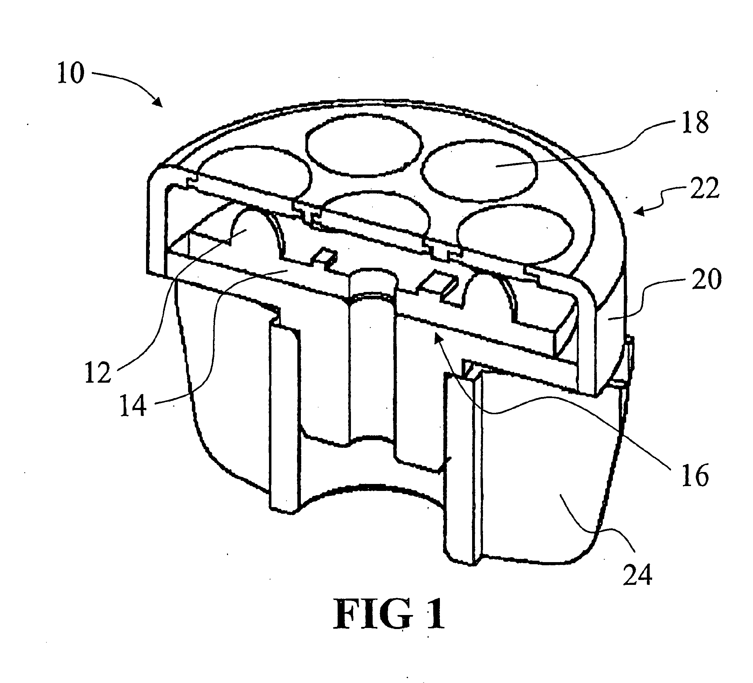

With reference to FIGURE **1**, a lamp that suitably practices an embodiment of the invention is described. A lamp or light source **10** includes a plurality of light emitting diodes (LED's) **12** arranged on a base or substrate **14,** the combination of which forms an LED module **16.** A plurality of lenses **18** are arranged in conjunction with the LED's **12,** such that each LED **12** lies on the optical axis of one of the lenses **18.** The lenses **18** effectuate a collimation of the light emitted by the LED's **12,** so that the lamp output is a collimated or conical beam having a desired angle of divergence. Preferably, the LED's **12** are positioned closely to the lenses **18** to maximize the light captured. For this reason, the lenses **18** should be fast lenses, i.e., should have a low f number. These preferred lens optical properties are not readily obtainable using conventional lenses. Accordingly, fresnel lenses are advantageously used for the lenses **18** to provide very low f number behavior in a reasonably sized lens.

In the illustrated embodiment of FIGURE **1****,** there is a one-to-one correspondence between lenses **18** and LED's **12.** That is, each LED **12** is associated with a single lens **18.** This in turn allows each LED **12** to lie on the optical axis of its corresponding lens **18,** which maximizes the optical efficiency of the combination. In other words, the spatial pattern of the lenses **18** corresponds with the spatial pattern of the LED's **12.**

The lenses **18** are arranged on a zoom apparatus **20** which together with the lenses form an adaptive optical system **22.** The optical system **22** is relatively adjustable with respect the LED module **16** to enable a selectable distance separation along the optical axis between the lenses **18** and the LED's **12.**

Because the lamp **10** is intended for lighting applications, the LED's **12** preferably emit light at high intensities. This entails electrically driving the LED's **12** at relatively high currents, e.g., as high as a few hundred milliamperes per LED **12.** Because LED light emission is very temperature-sensitive, the heat dissipated in the LED's **12** as a consequence of the high driving currents is advantageously removed by a heat sink **24** which is thermally connected with the substrate **14.**

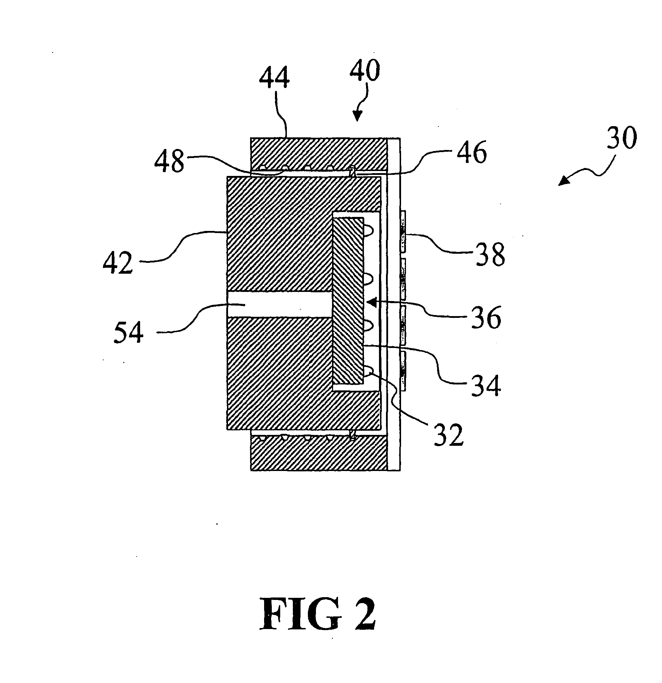

With reference now to FIGURES **2** through **4****,** a lamp **30** that suitably practices an embodiment of the invention in which the zoom apparatus operates on a mechanical sliding principle is described. LED's **32** are arranged on a substrate **34** forming an LED module **36.** A plurality of lenses **38,** which are preferably Fresnel lenses, are arranged in correspondence with the LED's **32,** with each LED **32** lying on the optical axis of an associated lens **38.** A sliding zoom apparatus **40** includes two slidably interconnecting elements or sleeves **42, 44.** The LED module **36** is arranged on or in the first sleeve **42** in a fixed manner. The lenses **38** are arranged on or in the second sleeve **44,** also in a fixed manner. It will be appreciated that zoom apparatus **40** of the lamp **30** effectuates beam width adjustment through the relative motion of the sleeves **42, 44.**

The configuration of the zoom apparatus **40** shown in FIGURE **2** corresponds to a minimum relative separation between the LED's **32** and the lenses **38.** This configuration produces a wide beam, i.e., a conical beam with a wide angle of divergence, sometimes called a flood light.

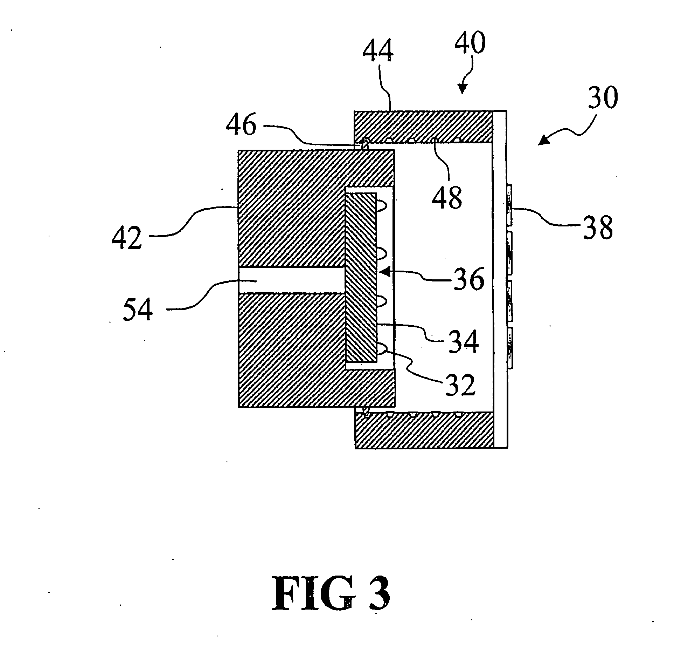

The configuration of the zoom apparatus **40** shown in FIGURE **3** corresponds to a maximum relative separation between the LED's **32** and the lenses **38.** This configuration produces a narrow beam, i.e., a conical beam with a small angle of divergence, sometimes called a spot light.

A sliding zoom apparatus can optionally effectuate continuous zoom adjustment (not shown). For continuous zoom adjustment, the sleeves should be of sufficiently close relative tolerances so that the frictional force between the two sleeves **42, 44** inhibits unintended sliding slippage therebetween.

Alternatively, as shown in the illustrated embodiment of FIGURES **2** and **3****,** the zoom apparatus **40** is an indexed zoom apparatus. A projection or stop **46,** which can be a single projection, a plurality of projections, or an annular projection, extends from the first sleeve **42** and is selectably moved into one of five recesses or stop positions **48,** which can be annular grooves, holes, or the like. The projection(s) **46** and the recesses **48** are mutually adapted to enable relative movement of the sleeves **42, 44** to selectably move the stop **46** to a selected stop position **48.** The projections or stop **46** and the recesses or stop positions **48** cooperate to bias the zoom apparatus into certain pre-selected axial spacings or stop positions. It will be appreciated that such an index system tends to reduce slippage between the two sleeves **42, 44** versus a similar continuous zoom adjustment which relies upon frictional force to prevent slippage. Of course, the index system of FIGURES **2** and **3** is exemplary only, and many variations thereof are contemplated, such as placing the stop onto the first sleeve and the recesses onto the second sleeve, using other than five stop positions, etc.

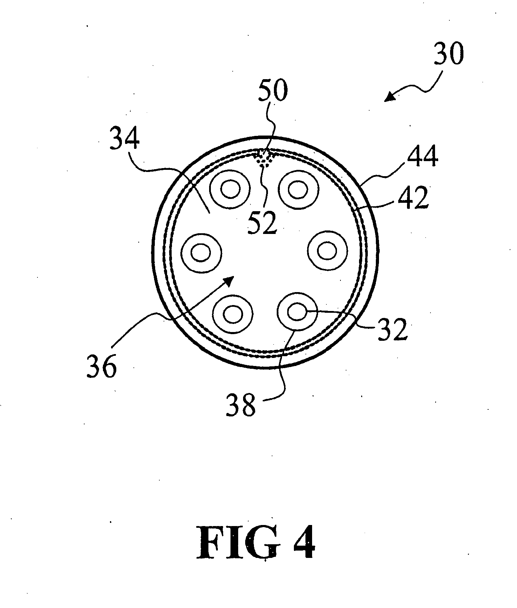

With reference to FIGURE **4****,** in addition to the zoom indexing system exemplarily effectuated by projection(s) **46** and recesses **48,** the lamp **30** also includes an advantageous interlocking mechanism including a linear projection **50** aligned along the sliding direction of the sliding zoom apparatus **40** and extending inwardly from the second sleeve **44** toward the first sleeve **42,** and a corresponding linear depression **52** that receives the linear projection **50.** This interlocking mechanism prevents relative rotation between the first and second sleeves **42, 44** so that the LED's **32** are maintained centered on the optical axes of the lenses **38.**

With reference to FIGURES **2** and **3****,** the lamp **30** also includes one or more electrical conduits **54** through which wires or other electrical conductors (not shown) connect the LED's to an associated power supply (not shown). Although an exemplary single conduit **54** is shown, numerous variations are contemplated, such as separate conduits for each LED **32.**

In addition, electrical components such as a printed circuit board that electrically connects the LED's **32** and has optional driving electronics operatively arranged thereupon, metallized connections, an associated battery or other electrical power supply, etc. are also contemplated (components not shown). It will be recognized that such electrical components are well known to those skilled in the art.

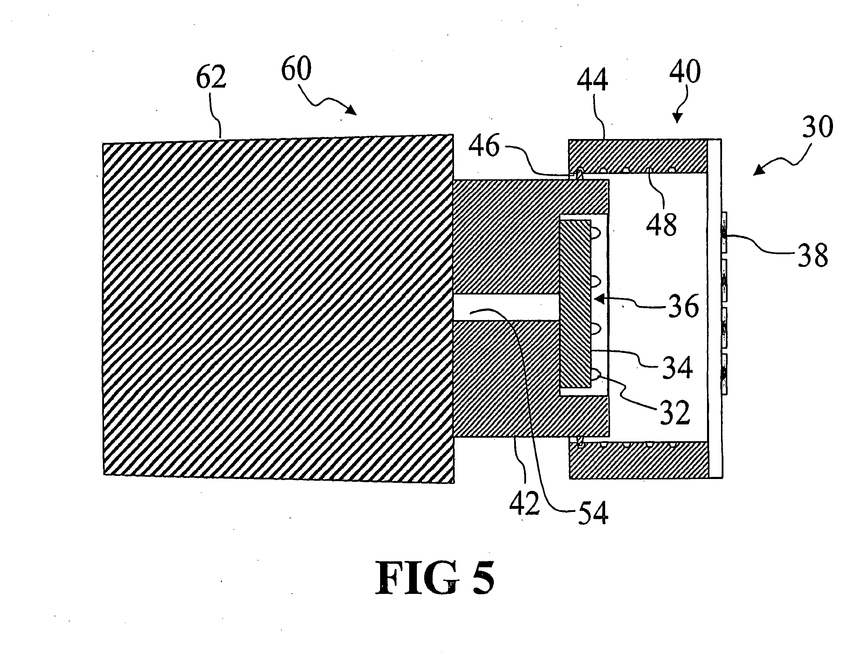

With reference to FIGURE **5**, a mounting configuration **60** for the lamp **30** of FIGURES **2** through **4** is described. In the mounting configuration **60,** the inner sleeve **42** remains fixed relative to a mounting element **62,** while the sliding movement of the outer sleeve **44** effectuates the zoom adjustment. The mounting element **62** could, for example, be the approximately cylindrical body of a hand flashlight that contains associated batteries to power the lamp **30,** in which case movement of the outer sleeve **44** is effectuated manually by the user. Alternatively, for a theater stage spotlight mounting configuration, the movement of sleeve **44** could be mechanized. It will be appreciated that the mounting configuration **60** is rather simple to construct because the adjustable outer sleeve **44** is accessible.

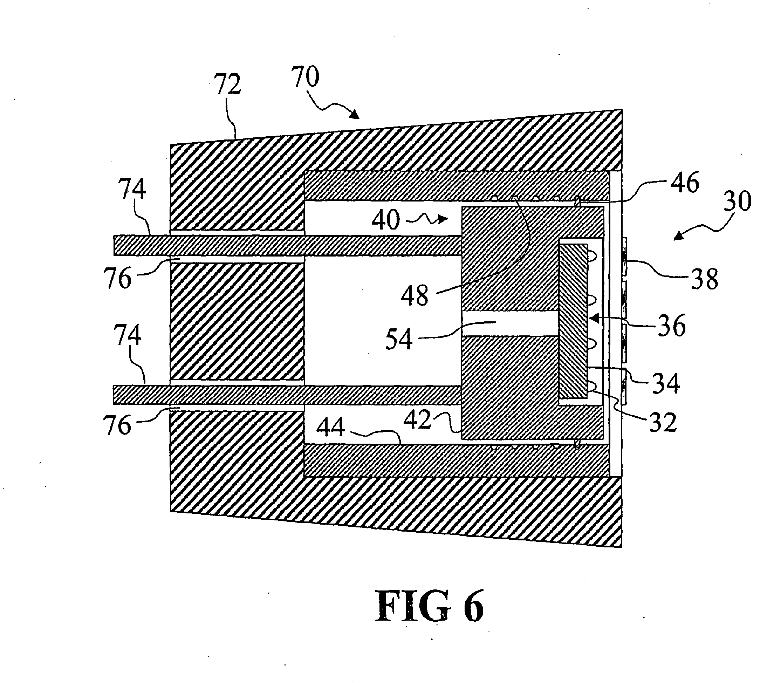

With reference to FIGURE **6****,** another mounting configuration **70** for the lamp **30** of FIGURES **2** through 4 is described. In the mounting configuration **70,** the outer sleeve **44** remains fixed relative to a mounting element **72,** while movement of the inner sleeve **42** effectuates the zoom adjustment. In this case, the inner sleeve **42** is relatively inaccessible from outside the mounting configuration **70,** and so in the embodiment of FIGURE **6** one or more posts **74** are rigidly affixed to the inner sleeve **42** and pass through passthroughs **76** in the mounting element **72** to provide handles or shafts by which the inner sleeve **42** is slidably adjusted to effectuate the zoom. The mounting configuration **70** is therefore more complex versus the mounting configuration **60** of FIGURE **5****.** However, the mounting configuration **70** has the advantage of fully containing the lamp **30** within the mounting element **72** so that a lighting device that employs the configuration **70** has definite and fixed outside dimensions. The one or more posts **74** are also easily adapted to connect with a motor (not shown) to effectuate a mechanized zoom adjustment.

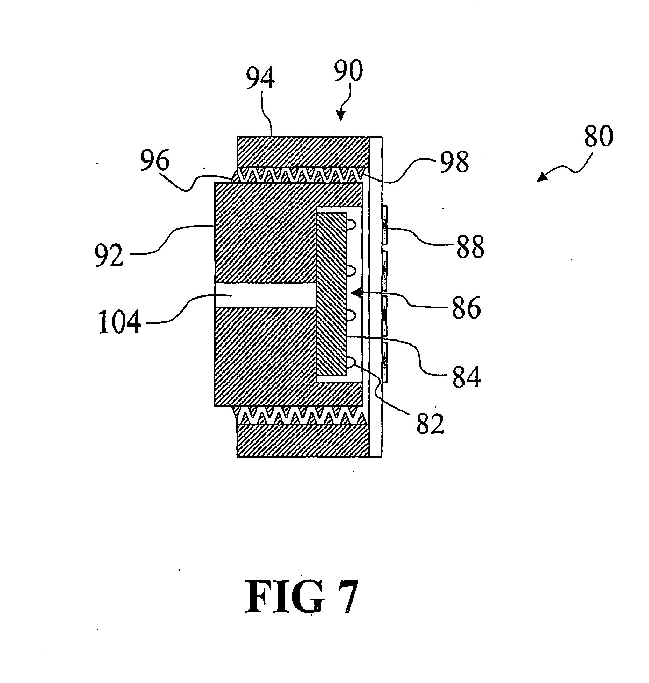

With reference to FIGURE. **7****,** a lamp **80** that suitably practices another embodiment of the invention in which the zoom apparatus operates on a mechanical rotation principle is described. LED's **82** are arranged on a substrate **84** forming an LED module **86.** A plurality of lenses **88,** which are preferably Fresnel lenses, are arranged in the same pattern as the LED's **82.** The rotating zoom apparatus **90** includes two threadedly interconnecting elements or sleeves **92, 94.** The LED module **86** is arranged on or in the first sleeve **92** in a fixed manner. The lenses **88** are arranged on or in the second sleeve **94,** also in a fixed manner. Thus, by relatively screwing the first and second sleeves **92, 94** into or out of each other using the cooperating threads **96, 98** disposed on the outside of the first sleeve **92** and the inside of the second sleeve **94,** respectively, the relative axial separation of the LED's **82** and the lenses **88** is adjusted. The first sleeve **92** preferably includes one or more electrical conduits **104** which are analogous to the conduit or conduits **54** of the embodiment of FIGURE **2****.**

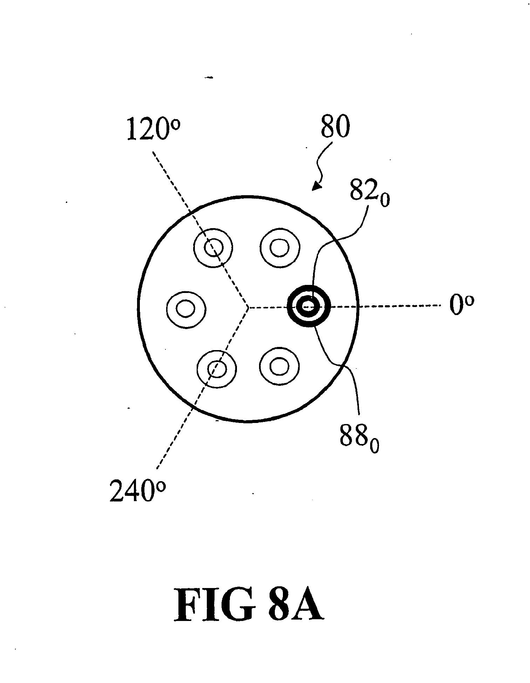

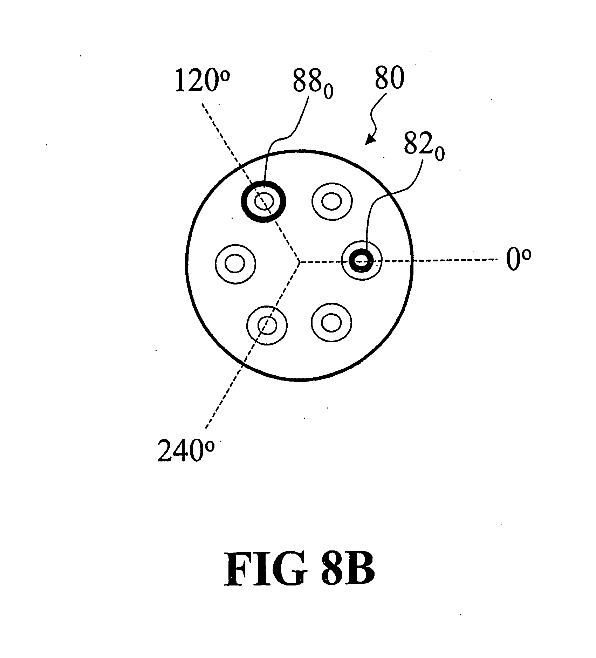

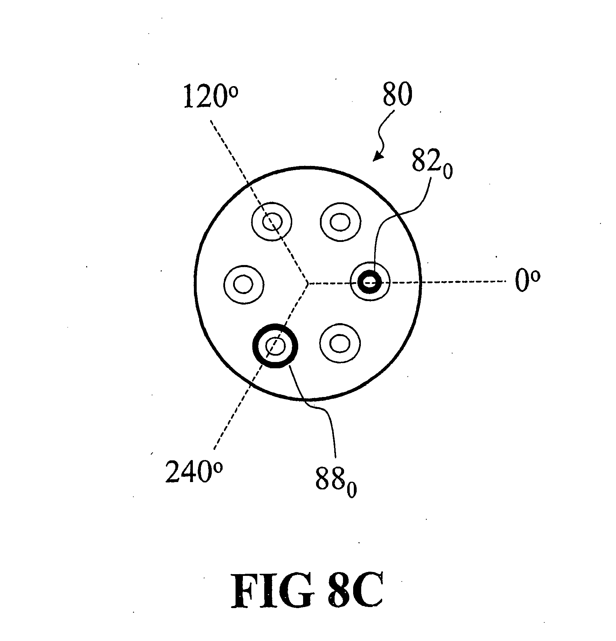

Although the LED's **82** and the lenses **88** are arranged in the same spatial pattern, it will be recognized that the rotating motion in general results in a misalignment of the LED's **82** off the optical axes of the lenses **88.** However, for certain relative rotational orientations of the sleeves **92, 94,** the two patterns align, as shown in FIGURE **8A****.** The relative rotational orientation shown in FIGURE **8A** is herein designated as 0° and serves as a reference orientation. Furthermore, a specific LED **82₀**, and a specific lens 88₀, are shown in bold in FIGURE **8A** and will be tracked during zoom adjustment using FIGURES **8B** and **8C** in the discussion which follows.

With reference to FIGURE **8B****,** the reference orientation has been changed by rotating the second sleeve **94** counter-clockwise by 120°. Two changes result from the 120° rotation. First, the axial separation of the LED's **82** and the lenses **88** changes by an amount related to the spacing of the threads **96, 98** due to the screwing action. Second, the lens **88₀** is no longer axially aligned with the LED **82₀,** but rather now axially aligns with another LED as seen in FIGURE **8B****.**

With reference to FIGURE **8C****,** the second sleeve, **94** has been rotated counter-clockwise by another 120° (240° total rotation versus FIGURE **8A****).** The axial separation of the LED's **82** and the lenses **88** is again changed by an amount related to the spacing of the threads **96, 98,** and the lens **88₀** : axially aligns with yet another LED as seen in FIGURE **8C****.** Although not illustrated as a separate figure, it will be recognized that a third counter-clockwise rotation of 120° would bring the total rotation versus FIGURE **8A** up to 360°, i.e. one complete rotation, and would re-produce the pattern alignment shown in FIGURE **8A****,** but with a change in axial spacing between the LED's **82** and the lenses **88** corresponding to the spacing of the threads **96, 98.**

In one aspect of the embodiment, the threads **96, 98** have thread joints, indented stops or another mechanism (not shown) to bias the zoom apparatus **90** into indexed positions such as those shown in FIGURES **8A****,** **8B****,** and **8C** wherein the lens **88** pattern aligns with the LED **82** pattern, It will be recognized that if the lens **88** pattern and the LED **82** pattern each have an n-fold rotational symmetry, then separation of the rotational stop positions by integer multiples of 360°/n enables stop positions for which each LED **82** is axially aligned with one of the plurality of lenses **88.** In the exemplary embodiment shown in FIGURES **8A****,** **8B** and **8C**, the patterns have six-fold rotational symmetry (n=6), and the stop positions are separated by 2×(360°/n) = 120**°** rotations.

In another aspect of the embodiment, the rotation of the zoom apparatus 90 can also be continuous with no index biasing. In this case the fractional interaction between the threads **96, 98** should be sufficient to counteract slippage of the zoom apparatus **90.**

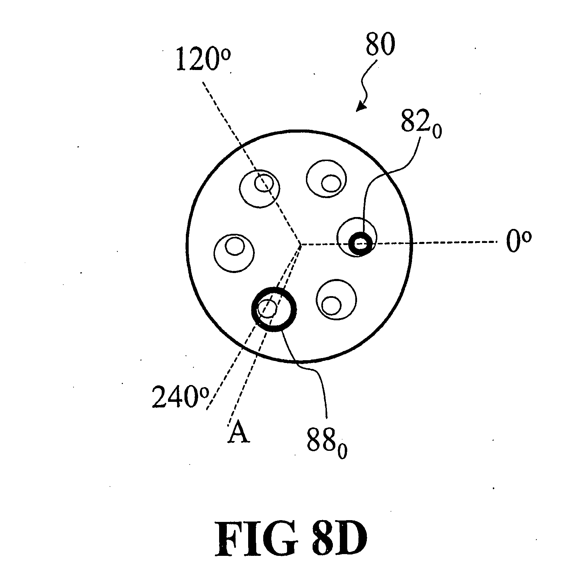

FIGURE **8D** shows a relative rotational orientation of the LED **82** pattern and the lenses **88** pattern wherein the LED's **82** are not axially aligned with the lenses **88,** but rather are relatively positioned slightly off-axis. It will be recognized that a relative pattern orientation such as that shown in FIGURE **8D** can be obtained either with or without index biasing. Such a slightly off-axis relative orientation produces defocusing which can provide further freedom for adjusting the light beam properties. In FIGURE **8D****,** the second sleeve **94** has been rotated to an angle **A** relative to the reference rotational orientation of FIGURE **8A****,** where the angle **A** is slightly greater than the 240° orientation that would produce pattern alignment.

In the embodiments of FIGURES **1-8D** the LEDs are shown as substantially similar, and the beam spot size or other beam characteristics is changed by relative mechanical movement of a lensing system and an LED assembly. However, the LEDs can be different. Moreover, in other embodiments, described next, beam spot size or other beam characteristics are changed by selectively energizing selected LEDs or sets of LEDs in which the LEDs or sets of LEDs are different and/or have different coupled optics.

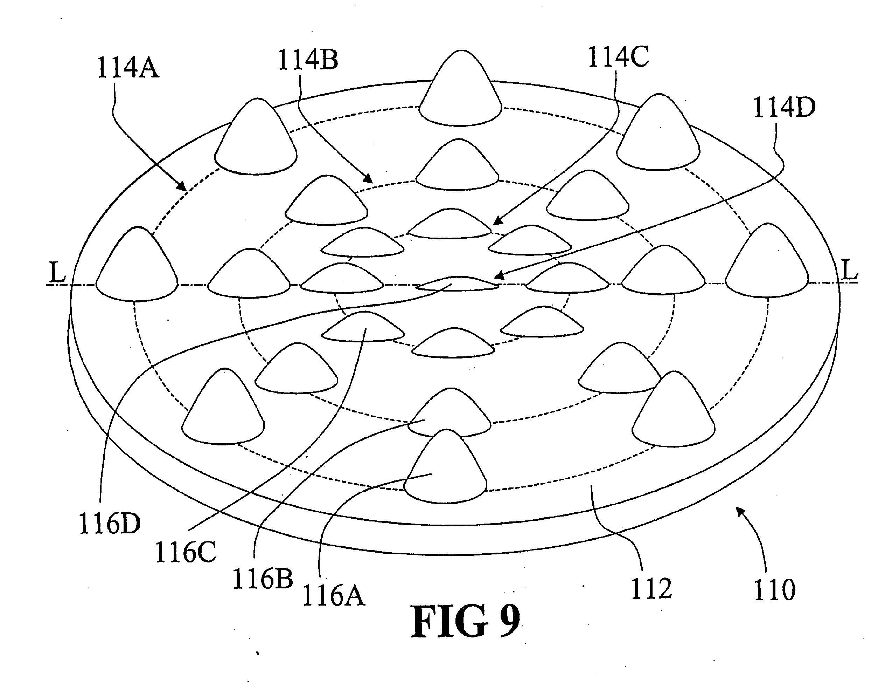

With reference to FIGURE **9****,** a lamp or light source **110** includes a substrate **112** which in the embodiment of FIGURE **9** is circular in shape. Arranged on the substrate **112** are a plurality of optical sources or lighting units **114A, 114B, 114C, 114D.** Each of the lighting units or optical sources **114A, 114B, 114C, 114D** include one or more light emitting diode (LED) components. The optical source **114A** comprises eight LED components **116A.** The optical source **114B** comprises eight LED components **116B.** The optical source **114C** comprises eight LED components **116C.** The optical source **114D** comprises only a single LED component **116D.** In the embodiment of FIGURE **9****,** the lighting unit **114D** that includes only a single LED component **116D** is located at the center of the substrate **112.** The lighting units **114C, 114B,** and **114A** are arranged in concentric circular patterns of increasing diameter, respectively, about the lighting unit **114D.**

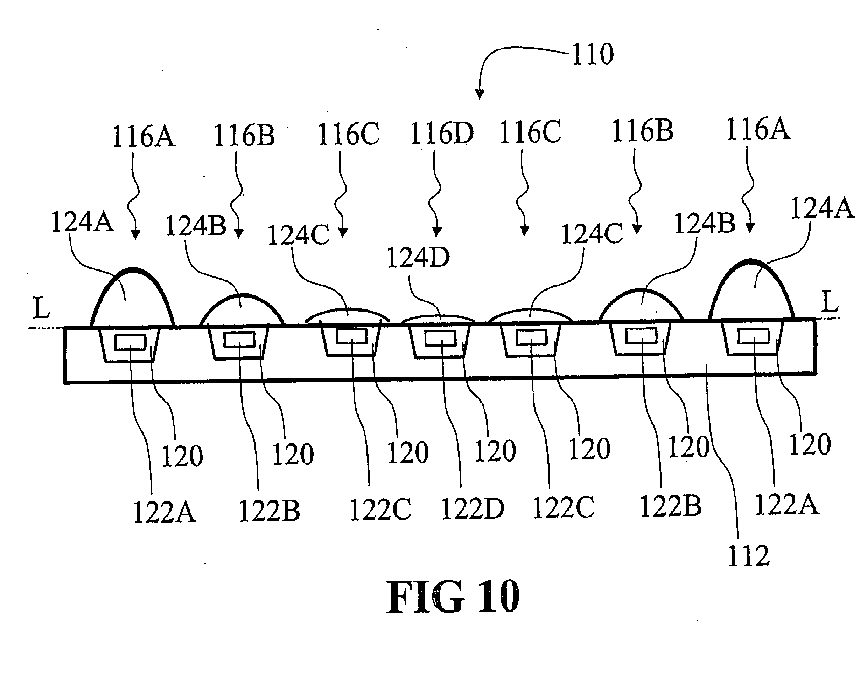

With continuing reference to FIGURE **9** and with further reference now to FIGURE **10****,** an embodiment of the LED components **116A, 116B, 116C, 116D** is described. FIGURE **10** shows a cross-sectional view of the lamp or light source **110** taken perpendicular to the substrate **112** along the Line **L-L** shown in FIGURE **9****.** A plurality of wells **120** are formed in the substrate **112** for receiving LED elements **122A, 122B, 122C, 122D** that correspond to the LED components **116A, 116B, 116C. 116D,** respectively. The substrate **110** is manufactured using a thermal heat sinking material such as a copper plate. Mounting of the LED elements and electrical contacting thereof are steps that are well known to the art and need not be described herein for an enabling disclosure.

It will be appreciated that the LED elements **122A, 122B, 122C, 122D** need not be identical to one another, but can instead include LED elements emitting light at different colors or with different spectral distributions, different optical intensities, and the like. The LED elements **122A, 122B, 122C, 122D** can be manufactured from different materials, e.g. LED element **122A** can be a group III-nitride LED element emitting blue light, wheres LED element **122B** can be a group III-phosphide LED element emitting red light. Furthermore, in the case of a plurality of LED elements comprising a lighting unit or optical source, e.g. the optical source **114A,** every LED element of the plurality need not be identical. For simplicity, however, FIGURE 2 shows all the LED elements **122A, 122B, 122C, 122D** as being essentially identical.

The LED components **116A, 116B, 116C, 116D** also include optical elements such as lenses **124A, 124B, 124C, 124D.** In order to effectuate different angular distributions or spatial patterns for the light emitted by the lighting units **114A, 114B, 114C, 114D,** the corresponding optical elements or lenses **124A, 124B, 124C, 124D** each have different optical prescriptions. The lenses **124A, 124B, 124C, 124D** can be discrete elements that are mounted above the wells **120.** Alternatively, the optical elements **124A, 124B, 124C, 124D** can be formed by controlled shaping or molding of an epoxy or resin encapsulant that is used to hermetically seal the LED elements **122A, 122B, 122C, 122D.** In the illustrated embodiment of FIGURES **9** and **10****,** the different optical prescriptions are effectuated by different radii of the conic of the lenses or epoxy "bumps" **124A, 124B, 124C, 124D.** Of course, other approaches for effectuating a pre-selected optical prescription can also be employed, such as by using different materials having different refractive indexes for each type of optical element **124A, 124B, 124C, 124D.** It will also be appreciated that the optical elements **124A, 124B, 124C, 124D** can, in addition to effectuating pre-selected optical prescriptions, also alter the light emitted by the optical sources **114A, 114B, 114C, 114D** in other ways. For example, the optical elements or lenses **124A, 124B, 124C, 124D** can be selectively tinted to alter the color or spectral distribution of the light passing therethrough in a pre-selected manner.

The embodiment illustrated in FIGURE **10** is exemplary only. Other configurations for the LED components **116A, 116B, 116C, 116D** and for the substrate **112** are also contemplated. For example, the substrate **112** can be a printed circuit board (PC board) with the LED elements **122A, 122B, 122C, 122D** bonded directly thereto. The wells **120** would typically be omitted in this alternate embodiment.

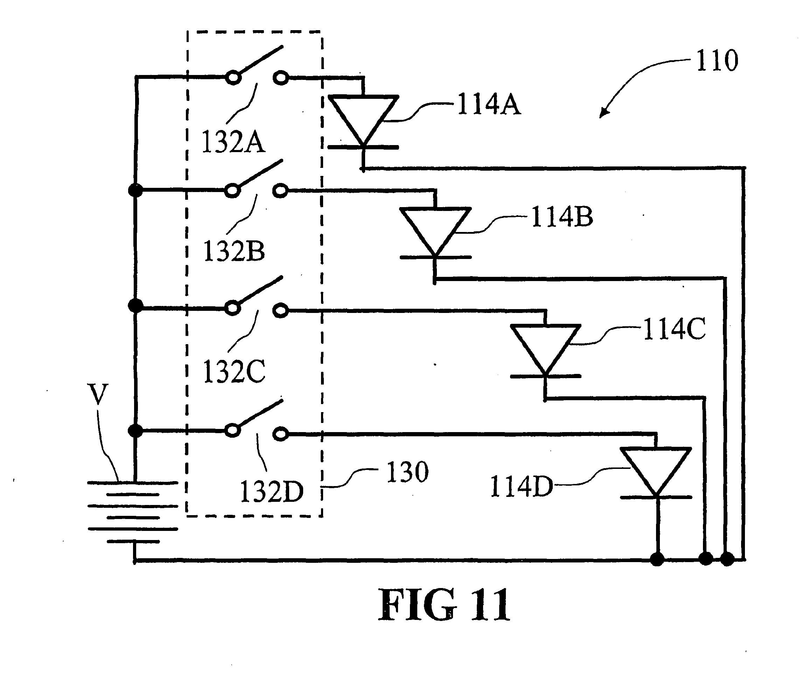

With reference now to FIGURE **11****,** the electrical configuration of the embodiment of FIGURES **9** and **10** is described. An associated voltage source **V** provides electrical power for the light source or lamp **110** that in the embodiment of FIGURES **9** and **11** includes four optical sources or lighting units **114A, 114B, 114C, 114D.** The lamp **110** further includes a control unit **130** that has four switches **132A, 132B, 132C, 132D** for selectively applying electrical power to the corresponding lighting units **114A, 114B, 114c, 114D.** The switches **132A, 132B, 132C, 132D** can be manual switches, electronically controlled switches, or other switch types. The control unit **130** optionally includes additional elements (not shown) such as a computer interface or components for conditioning the power applied to the lighting units. In the illustrated electrical configuration of FIGURE **11****,** the four lighting units **114A, 114B, 114C, 114D** are independently selectable, and any combination of the lighting units **114A, 114B, 114C, 114D** can be selectively powered at any given time. Each of the lighting units **114A, 114B, 114C, 114D** has a different optical prescription, obtained in the embodiment of FIGURES **9** and **10** by using different conic radii for the lenses **124A, 124B, 124C, 124D.** Thus, by operating only a selected one of the four lighting units **114A, 114B, 114C, 114D** four different angular distributions or spatial patterns of emitted light can be selectively obtained. By operating a selected sub-set of the plurality of optical sources **114A, 114B, 114C, 114D,** complex combinations of the spatial light distributions of the individual optical sources **114A, 114B, 114C, 114D** can be obtained. In a limiting operational case, all four optical sources **114A, 114B, 114C, 114D** can be operated simultaneously using the electrical configuration shown in FIGURE **11****.**

The electrical configuration of FIGURE **11** is exemplary only, and a number of variations thereof are contemplated. As noted previously, the LED elements **122A, 122B, 122C, 122D** can be of different types, e.g. GaN LED elements, InGaAIP LED elements, and so forth. In cases where the LED elements comprising the lighting units differ, the control unit **130** optionally includes voltage dividers (not shown) or other power conditioning components that control the power applied to each optical source **114A, 114B, 114C, 114D.** Furthermore, as noted previously a given optical source, e.g. optical source **114A,** can include LED elements of different types. In this case, the optical source **114A** would itself include one or more electrical components (not shown) such as voltage dividers that condition the voltage applied to each LED element within the optical source **114A.** In yet another variant, the control unit **130** includes a rheostat, variable voltage divider, or other electrical component (not shown) that enables variable power application to the lamp **110** as a whole or to one or more of the individual lighting units **114A, 114B, 114C, 114D** that are included in the lamp **110.** Such an arrangement advantageously enables the user to control the optical intensity as well as the spatial distribution of the light output.

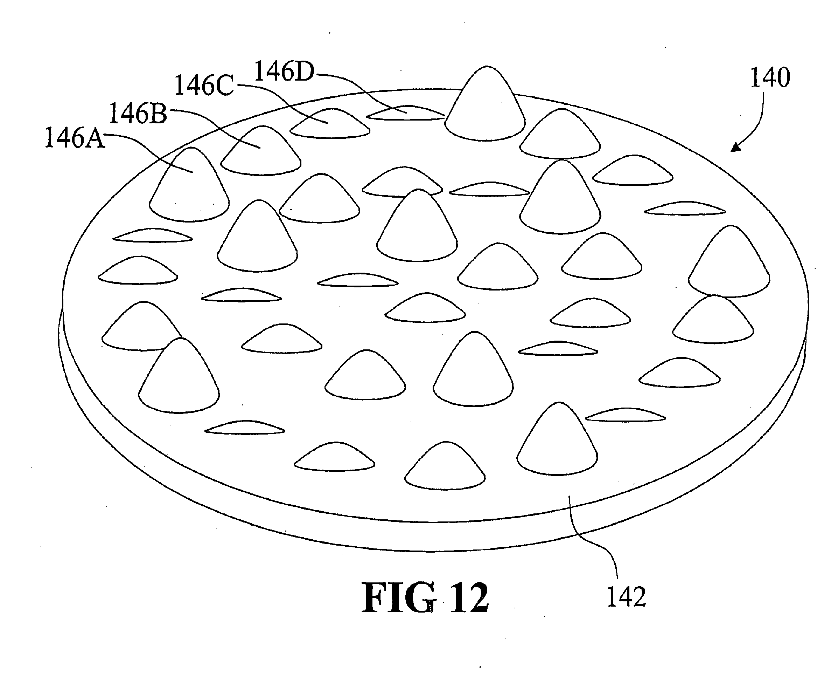

With reference now to FIGURE **12****,** a second embodiment **140** of the invention is described. A circular substrate **142** has four lighting units arranged thereon. Each lighting unit includes a plurality of essentially identical LED components. The LED components of each lighting unit differ from the LED components of the other three lighting units. Hence, there are four LED component types **146A, 146B, 146C, 146D** arranged on the substrate **142,** corresponding to the four lighting units. Unlike the embodiment of FIGURE 9, the embodiment of FIGURE **12** has an equal number of LED components of each type, and the distribution of the LED component types **146A, 146B, 146C, 146D** across the substrate **142** is essentially uniform. Although the spatial distribution of the LED component types is uniform, the lamp **140** nonetheless is capable of producing light having at least four selectable spatial or angular distributions because each of the four LED component types **146A, 146B, 146C, 146D** has a different optical prescription, as indicated by the different conic radii of the four LED component types **146A, 146B, 146C, 146D.** Thus, the corresponding four lighting units each produce light having a different spatial or angular light distribution.

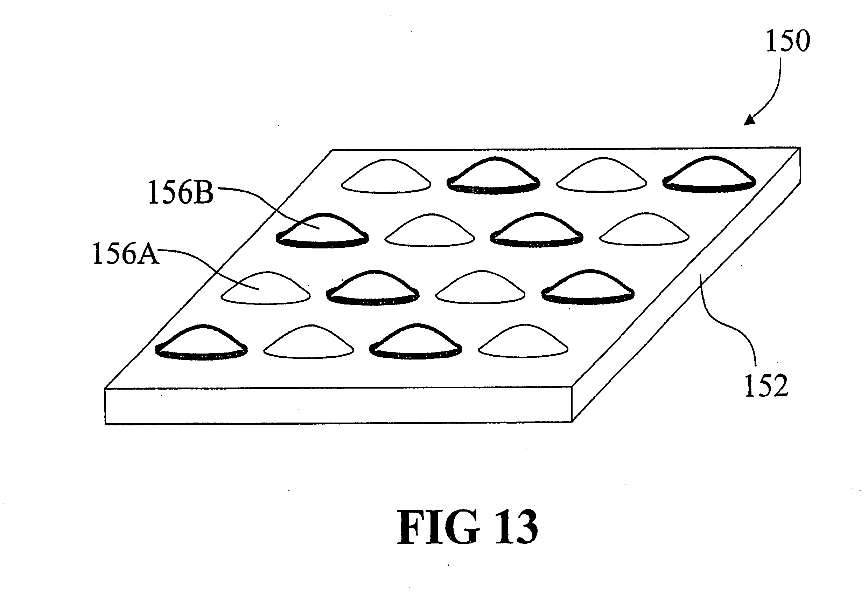

With reference now to FIGURE **13****,** a third embodiment **150** of the invention is described. A rectangutar substrate **152** has two lighting units corresponding to LED components of types **156A** and **156B,** respectively. The LED component types **156A, 156B** have optical elements with essentially similar conic radii. However, different optical prescriptions are obtained by using materials having different refractive indexes for the optical elements of each component type **156A, 156B.** Hence, the embodiment of FIGURE **13** has a first angular or spatial light distribution obtained when the first optical source comprising the LED components of type **156A** are activated; and a second angular or spatial light distribution obtained when the second optical source comprising the LED components of type **156B** are activated. Optionally, a third angular or spatial light distribution can be obtained by activating both the first and the second optical sources together, the third angular or spatial distribution operatively combining the first and the second light output distributions.

Those skilled in the art will appreciate that embodiments of the type **110, 140, 150** in which beam spot size or other beam characteristics are changed by selectively energizing selected LEDs or sets of LEDs are readily combined with the embodiments of the type **10, 30, 80** in which the beam characteristics are varied by relative mechanical movement of a lensing system and an LED assembly.

For example, the light source **110** of FIGURE **9** has an eight-fold rotational symmetry that is particularly suitable for use in a rotationally adjustable spot module lamp similar to the lamp **80** of FIGURE **7****.** The light source **110** suitably replaces the LED module **86** of the lamp 80. The lenses **124** in one contemplated embodiment are located on the second sleeve **94,** that is the lenses **124** replace the lenses **88** of the spot module **80.** In another contemplated embodiment the lenses **124** are affixed to the light source **110** as shown in FIGURE **9****,** and the lenses **88** are separate lenses that cooperate with the lenses **124** to provide the selected optical focusing. The light sources **140, 150** are less suitable for a rotationally adjustable spot module lamp, since these sources **140, 150** would require a 360° rotation. However, any of the light sources **110, 140, 150** are suitably used in conjunction with a slidably adjustable spot module lamp similar to the lamp **30** of FIGURES **2-4****.**

The invention has been described with reference to the preferred embodiments. Obviously, modifications and alterations will occur to others upon reading and understanding the preceding detailed description. It is intended that the invention be construed as including all such modifications and alterations insofar as they come within the scope of the appended claims or the equivalents thereof.

Further aspects of the invention are set forth in the following numbered paragraphs:
1. A spot module having a selectable light output, the spot module including:
   a substrate **(14, 34, 84, 112, 142, 152);**
   a plurality of optical sources **(114A, 114B, 114C, 114D)** arranged on the substrate **(14, 34, 84, 112, 142, 152),** each optical source **(114A, 114B, 114C, 114D)** including:
      at least one light emitting diode **(116A, 116B, 116C, 116D, 146A, 146B, 146C, 146D, 156A, 156B),** and
      at least one optical element **(18, 38, 88)** in operative communication with the at least one light emitting diode **(116A, 116B, 116C, 116D, 146A, 146B, 146C, 146D, 156A, 156B)** and having a pre-defined optical prescription; and
   a zoom apparatus **(20, 40, 90)** supporting the optical elements **(18, 38, 88)** of the optical sources **(114A, 114B, 114C, 114D),** the zoom apparatus **(20, 40, 90)** adjusting an axial separation between the at least one light emitting diode **(116A. 116B, 116C, 116D, 146A, 146B, 146C, 146D, 156A, 156B)** of each optical source **(114A, 114B, 114C, 114D)** and its corresponding at least one optical element **(18, 38, 88).**
2. The spot module of paragraph 1, wherein each of the plurality of optical sources **(114A, 114B, 114C, 114D)** produces light having selected output characteristics, the selected output characteristics differing for each of the optical light sources **(114A, 114B, 114C, 114D),** the spot module further including:
   a control unit (130) that selectively operates a selected one or more of the optical sources **(114A, 114B, 114C, 114D)** to produce light having selected light output characteristics.
3. The spot module of paragraph 2, wherein the selective operation of the plurality of optical sources **(114A, 114B, 114C, 114D)** includes at least one of:
   selectively operating one of the plurality of optical sources **(114A, 114B, 114C, 114D);**
   selectively operating a sub-set of the plurality of optical sources **(114A, 114B, 114C, 114D);** and
   selectively operating all of the plurality of optical sources **(114A, 114B, 114C, 114D).**
4. The spot module of paragraph 1, wherein the zoom apparatus **(40)** includes:
   two slidably interconnected sleeves **(42, 44),** the first sleeve (42) being connected with the at least one light emitting diode **(116A, 116B, 116C, 116D, 145A, 146B, 146C, 146D, 156A, 156B)** and the second sleeve **(44)** being connected with the at least one optical element **(38).**
5. The spot module of paragraph 1, wherein the zoom apparatus **(90)** includes:
   two threadedly interconnected sleeves **(92, 94),** the first sleeve **(92)** being connected with the at least one light emitting diode **(116A, 116B, 116C, 116D, 146A, 146B, 146C, 146D, 156A, 156B)** and the second sleeve **(94)** being connected with the at least one optical element **(88).**
6. The spot module of paragraph 1, wherein the at least one optical element **(18, 38, 88)** includes a lens **(18, 38, 88)** corresponding to each light emitting diode **(116A, 116B, 116C, 116D, 146A, 146B, 146C, 146D, 156A, 156B),** the lens receiving and focusing light from the light emitting diode **(116A, 116B, 116C, 116D, 146A, 146B, 146C, 146D, 156A, 156B).**
7. The spot module of paragraph 6, wherein each light emitting diode further includes:
   an epoxy or resin encapsulant **(124A, 124B, 124C, 124D)** that hermetically seals the light emitting diode, the epoxy or resin encapsulant **(124A, 124B, 124C, 124D)** providing light refraction that cooperates with the lens (18, 38, 88) to focus the right
8. A lamp including:
   an LED module **(16, 36, 86)** including at least one LED **(12, 32, 82)** arranged on a substrate **(14, 34, 84);**
   an optical system comprising at least one lens **(18, 38, 88)** in optical communication with the LED module **(16, 36, 86);** and
   a zoom apparatus **(20, 40, 90)** that selectively adjusts the relative axial separation of the optical system and the LED module **(16, 36, 86).**
9. The lamp of paragraph 8, wherein the LED module **(16, 36, 86)** includes:
   a plurality of LED's **(12, 32, 82)** arranged in a first pattern on the substrate **(14, 34, 84).**
10. The lamp as of paragraph 9, wherein the at least one lens **(18, 38, 88)** includes:
   a plurality of Fresnel lens arranged in a second pattern that corresponds with the first pattern.
11. The lamp of paragraph 9, wherein the optical system includes:
   a plurality of lenses **(18, 38, 88)** wherein each lens is axially aligned with an LED **(12, 32, 82)** and optically communicates with said LED **(12, 32, 82).**
12. The lamp of paragraph 9, wherein the plurality of LEDs **(12, 32, 82)** of the LED module **(16, 36, 86)** include:
   a first LED lighting unit **(114A)** including a plurality of first LEDs **(116A, 146A, 156A)** that produce light having first characteristics; and
   a second LED lighting unit **(114B)** including a plurality of second LEDs **(116B, 146B, 156B)** that produce light having second characteristics which are different from the first characteristics;
   wherein the first and second LED lighting units **(114A. 114B)** are selectively operated to produce light output with a selected one of the first and second characteristics.
13. The lamp of paragraph 8, wherein the zoom apparatus **(90)** includes:
   a first sleeve **(92)** having the LED module **(86)** arranged thereon, the first sleeve **(90)** further having a first threading **(96)** arranged thereon; and
   a second sleeve **(94)** having a second threading **(98)** arranged thereon that is adapted to cooperate with the first threading **(96)** such that the first sleeve **(92)** and the second sleeve **(94)** are relatively movable in a screwing fashion, the second sleeve **(94)** further having the optical system arranged thereon.
14. The lamp of paragraph 13, further including:
   an index system that relatively biases the first sleeve **(92)** and the second sleeve (94) into one or more selectable relative axial positions.
15. The lamp of paragraph 8, wherein the zoom apparatus **(40)** includes:
   a first element **(42)** having the LED module **(36)** disposed thereon; and
   a second element **(44)** adapted to slidingly connect with the first element **(42),** the second element **(44)** further having the optical system disposed thereon.
16. The lamp of paragraph 15, wherein the zoom apparatus **(40)** further includes:
   a mechanical interlock **(50, 52)** between the first and the second elements **(42, 44)** that prevents relative rotation therebetween.
17. The lamp of paragraph 16, wherein the mechanical interlock **(50, 52)** includes:
   a protrusion **(50)** on one of the first and the second elements **(42, 44),** the protrusion **(50)** being aligned parallel to the optical axis; and
   a groove **(52)** on one of the first and the second elements **(42, 44)** that receives the protrusion (50) to prevent relative rotation of the first and the second elements **(42, 44).**
18. The lamp of paragraph 15, further including:
   a stop **(46)** that relatively biases the first and the second elements **(42,** 44) into one or more selectable relative axial stop positions **(48).**
19. The lamp of paragraph 8, wherein the LED module **(16)** further including:
   a heat sink **(24)** thermally connected with the substrate **(14)** for cooling the LED module **(16).**

## Claims

1. A lamp including:
an LED module (86) including at least one LED (82) arranged on a substrate (84);
at least one lens (88) in optical communication with the LED module (86) along an optical axis between the at least one lens (88) and the at least one LED (82); and
a zoom apparatus (90) that selectively adjusts the relative axial separation of the at least one lens (88) and the LED module (86), **characterized in that** the zoom apparatus (90) includes:
two threadedly interconnected sleeves (92, 94), the first sleeve (92) being connected with the at least one LED (82) and the second sleeve (94) being connected with the at least one lens (88).

2. The lamp as set forth in claim 1, wherein the zoom apparatus (90) includes:
a first sleeve (92) having the LED module (86) arranged thereon or therein, the first sleeve (92) further having a first threading (96) arranged thereon; and
a second sleeve (94) having a second threading (98) arranged thereon that is adapted to cooperate with the first threading (96) such that the first sleeve (92) and the second sleeve (94) are relatively movable in a screwing fashion, the second sleeve (94) further having the at least one lens (88) arranged thereon or therein.

3. A lamp including:
an LED module (16, 36) including at least one LED (12, 32) arranged on a substrate (14,34);
at least one lens (18, 38) in optical communication with the LED module (16, 36) along an optical axis between the at least one lens (18, 38) and the at least one LED (12, 32); and
a zoom apparatus (20, 40) that selectively adjusts the relative axial separation of the at least one lens (18, 38) and the LED module (16, 36), **characterized in that**
the zoom apparatus (40) includes:
two slidably interconnected elements (42, 44), the first element (42) being connected with the at least one LED (32) and the second element (44) being connected to the at least one lens (38).

4. The lamp as set forth in claim 3, wherein the zoom apparatus (40) includes:
a first element (42) having the LED module (36) disposed thereon; and
a second element (44) adapted to slidingly connect with the first element (42) , the second element (44) further having the at least one lens (18, 38) disposed thereon.

5. The lamp as set forth in claim 3 or 4 wherein the zoom apparatus (40) further includes:
a mechanical interlock (50, 52) between the first and second elements (42, 44) that prevents relative rotation therebetween.

6. The lamp as set forth in claim 5, wherein the mechanical interlock (50, 52) includes:
a protrusion (50) on one of the first and second elements (42, 44), the protrusion (50) being aligned parallel the optical axis; and
a groove (52) on one of the first and second elements (42, 44) that receives the protrusion (50) to prevent relative rotation of the first and second elements (42, 44).

7. The lamp as set forth in any one of claims 3 to 6, wherein the first element (42) is slidably interconnected to the second element (44) with sufficiently close relative tolerances so that frictional force between the two elements inhibits unintended sliding slippage therebetween.

8. The lamp as set forth in any one of the preceding claims, wherein the LED module (16) further including:
a heat sink (24) thermally connected with the substrate (14) for cooling the LED module (16).

9. The lamp as set forth in any one of the preceding claims further comprising electrical wiring connecting the at least one LED (12, 32, 84) to a source of electrical power and a conduit (54, 104) for passing the electrical wiring from the at least one LED (12, 32, 84) to the source of electrical power.

## Patentansprüche

1. Lampe, die aufweist:
ein LED-Modul (86) mit mindestens einer LED (82), die auf einem Substrat (84) angeordnet ist,
mindestens eine Linse (88) in optischer Verbindung mit dem LED-Modul (86) längs einer optischen Achse zwischen der mindestens einen Linse (88) und der mindestens einen LED (82), und
eine Zoomvorrichtung (90), die den relativen axialen Abstand zwischen der mindestens einen Linse (88) und dem LED-Modul (86) auswählbar einstellt, **dadurch gekennzeichnet, dass** die Zoomvorrichtung (90) aufweist:
zwei über Gewinde miteinander verbundene Hülsen (92, 94), wobei die erste Hülse (92) mit der mindestens einen LED (82) verbunden ist und die zweite Hülse (94) mit der mindestens einen Linse (88) verbunden ist.

2. Lampe nach Anspruch 1, wobei die Zoomvorrichtung (90):
eine erste Hülse (92) umfasst, auf oder in der sich das LED-Modul (86) befindet, und die erste Hülse (92) darüber hinaus über ein erstes Gewinde (96) verfügt; und
eine zweite Hülse (94) umfasst, die über ein zweites Gewinde (98) verfügt, das so abgestimmt ist, dass es mit dem ersten Gewinde (96) zusammenwirkt, so dass die erste Hülse (92) und die zweite Hülse (94) schraubbeweglich zueinander sind, wobei sich auf oder in der zweiten Hülse (94) die mindestens eine Linse (88) befindet.

3. Lampe, die aufweist:
ein LED-Modul (16, 36) mit mindestens einer LED (12, 32), die sich auf einem Substrat (14, 34) befindet;
mindestens eine Linse (18, 38) in optischer Verbindung mit dem LED-Modul (16, 36) längs einer optischen Achse zwischen der mindestens einen Linse (18, 38) und der mindestens einen LED (12, 32); und
eine Zoomvorrichtung (20, 40), die den relativen axialen Abstand zwischen der mindestens einen Linse (18, 38) und dem LED-Modul (16, 36) auswählbar einstellt, **dadurch gekennzeichnet, dass** die Zoomvorrichtung (40):
zwei verschiebbar miteinander verbundene Elemente (42, 44) umfasst, wobei das erste Element (42) mit der mindestens einen LED (32) verbunden ist und das zweite Element (44) mit der mindestens einen Linse (38) verbunden ist.

4. Lampe nach Anspruch 3, wobei die Zoomvorrichtung (40) aufweist:
ein erstes Element (42), auf dem sich das LED-Modul (36) befindet; und
ein zweites Element (44), das so abgestimmt ist, dass es mit dem ersten Element (42) verschiebbar verbunden ist, wobei sich darüber hinaus auf dem zweiten Element (44) die meindestens eine Linse (18, 38) befindet.

5. Lampe nach Anspruch 3 oder 4, wobei die Zoomvorrichtung (40) darüber hinaus aufweist:
eine mechanische Arretierung (50, 52) zwischen dem ersten und dem zweiten Element (42, 44), die eine relative Verdrehung zwischen diesen verhindert.

6. Lampe nach Anspruch 5, wobei die mechanische Arretierung (50, 52) darüber hinaus aufweist:
einen Überstand (50) entweder an dem ersten oder an dem zweiten Element (42, 44), wobei der Überstand (50) parallel zur optischen Achse ausgerichtet ist; und
eine Nut (52) entweder an dem ersten oder an dem zweiten Element (42, 44), die den Überstand (50) aufnimmt, um eine relative Verdrehung des ersten und zweiten Elements (42, 44) zu verhindern.

7. Lampe nach einem der Ansprüche 3 bis 6, wobei das erste Element (42) mit dem zweiten Element (44) mit ausreichen engen Toleranzen verschiebbar verbunden ist, so dass die Reibungskraft zwischen den beiden Elementen ein unbeabsichtigtes verschiebendes Verrutschen zwischen diesen verhindert.

8. Lampe nach einem der vorhergehenden Ansprüche, wobei das LED-Modul (16) darüber hinaus über:
ein Kühlblech (24) verfügt, das mit dem Substrat (14) thermisch verbunden ist, um das LED-Modul (16) zu kühlen.

9. Lampe nach einem der vorhergehenden Ansprüche, wobei sie darüber hinaus über eine elektrische Leitung, die die mindestens eine LED (12, 32, 82) mit einer elektrischen Spannungsquelle verbindet sowie über einen Kanal (54, 104) zum Durchführen der elektrischen Leitung von der mindestens einen LED (12, 32, 82) an die elektrische Spannungsquelle verfügt.

## Revendications

1. Lampe, comprenant :
un module de DEL (86) comprenant au moins une DEL (82) disposée sur un substrat (84);
au moins une lentille (88) en communication optique avec le module de DEL (86) suivant un axe optique entre l'au moins une lentille (88) et l'au moins une DEL (82) ; et
un dispositif de zoom (90) qui ajuste sélectivement la séparation axiale relative de l'au moins une lentille (88) et du module de DEL (86), **caractérisée en ce que** le dispositif de zoom (90) comprend :
deux manchons interconnectés par vissage (92, 94), le premier manchon (92) étant relié à l'au moins une DEL (82) et le deuxième manchon (94) étant relié à l'au moins une lentille (88).

2. Lampe selon la revendication 1, dans lequel le dispositif de zoom (90) comprend :
un premier manchon (92) avec le module de DEL (86) disposé sur ou dans celui-ci, le premier manchon (92) comportant en outre sur celui-ci un premier filetage (96) ; et
un deuxième manchon (94) comportant sur celui-ci un deuxième filetage (98) qui est adapté pour coopérer avec le premier filetage (96) de manière que le premier manchon (92) et le deuxième manchon (94) soient mobiles réciproquement par vissage, le deuxième manchon (94) comprenant en outre l'au moins une lentille (88) disposée sur ou dans celui-ci.

3. Lampe, comprenant :
un module de DEL (16, 36) comprenant au moins une DEL (12, 32) disposée sur un substrat (14, 34) ;
au moins une lentille (18, 38) en communication optique avec le module de DEL (16, 36) suivant un axe optique entre l'au moins une lentille (18, 38) et l'au moins une DEL (12, 32) ; et
un dispositif de zoom (20, 40) qui ajuste sélectivement la séparation axiale relative de l'au moins une lentille (18, 38) et du module de DEL (16, 36), **caractérisée en ce que**
le dispositif de zoom (90) comprend :
deux éléments interconnectés de manière coulissante (42, 44), le premier élément (42) étant relié à l'au moins une DEL (32) et le deuxième élément (44) étant relié l'au moins une lentille (38).

4. Lampe selon la revendication 3, dans lequel le dispositif de zoom (90) comprend :
un premier élément (42) comportant le module de DEL (36) disposé sur celui-ci ; et
un deuxième élément (44) adapté pour se connecter de manière coulissante avec le premier élément (42), le deuxième élément (44) comportant en outre l'au moins une lentille (18, 38) disposée sur celui-ci.

5. Lampe selon la revendication 3 ou 4, dans lequel le dispositif de zoom (90) comprend en outre :
un verrouillage mécanique (50, 52) entre les premier et deuxième éléments (42, 44) qui empêche une rotation relative entre eux.

6. Lampe selon la revendication 5, dans lequel le verrouillage mécanique (50, 52) comprend :
une saillie (50) sur un des premier et deuxième éléments (42, 44), la saillie (50) étant alignée parallèlement à l'axe optique ; et
une rainure (52) sur un des premier et deuxième éléments (42, 44), qui reçoit la saillie (50) pour empêcher la rotation relative des premier et deuxième éléments (42, 44).

7. Lampe selon l'une quelconque des revendications 3 à 6, dans lequel le premier élément (42) est interconnecté de manière coulissante avec le deuxième élément (44) avec des tolérances relatives suffisamment étroites de manière que la force de frottement entre les deux éléments empêche un glissement de coulissement non intentionnel entre eux.

8. Lampe selon l'une quelconque des revendications précédentes, dans lequel le module de DEL (16) comprend en outre :
un dissipateur de chaleur (24) relié thermiquement au substrat (14) pour refroidir le module de DEL (16).

9. Lampe selon l'une quelconque des revendications précédentes, comprenant en outre un câblage électrique connectant l'au moins une DEL (12, 32, 84) à une source d'énergie électrique et une conduit (54, 104) pour passer le câblage électrique de l'au moins une DEL (12, 32, 84) à la source d'énergie électrique.
